# EUROPEAN PATENT SPECIFICATION

(11) **EP 3 075 040 B1**
(45) Date of publication and mention of the grant of the patent: **08.08.2018**
(21) Application number: 14865881.8
(22) Date of filing: 26.11.2014
(51) Int. Cl.: H01S 5/34

(54) **QUANTUM CASCADE LASER**
QUANTENKASKADENLASER
LASER À CASCADE QUANTIQUE

(30) Priority: 30.11.2013 US 201361910342 P
(43) Date of publication of application: 05.10.2016
(73) Proprietor: Thorlabs Quantum Electronics, Inc., Jessup MD 20794 (US)
(72) Inventor: CANEAU, Catherine, Genevieve, Jessup, MD 20794 (US); ZAH, Chung-eng, Jessup, MD 20794 (US); XIE, Feng, Jessup, MD 20794 (US)
(74) Representative: 2s-ip Schramm Schneider Bertagnoll Patent- und Rechtsanwälte Part mbB
(86) International application number: PCT/US2014/067646
(87) International publication number: WO 2015/081217

(56) References cited:
- EP-A1- 2 461 435
- EP-A2- 1 133 035
- WO-A1-2013/082070
- US-A- 6 137 817
- US-A1- 2012 230 359
- US-A1- 2013 266 036
- FEDERICO CAPASSO ET AL: "High-Performance Superlattice Quantum Cascade Lasers", IEEE JOURNAL OF SELECTED TOPICS IN QUANTUM ELECTRONICS, IEEE SERVICE CENTER, PISCATAWAY, NJ, US, vol. 5, no. 3, June 1999 (1999-06), XP011062515, ISSN: 1077-260X

## Description

### BACKGROUND

The present disclosure relates generally to quantum cascade devices such as optical amplifier chips used as in integrated or external cavity quantum cascade lasers (QCLs), ASE sources, and similar applications, with high continuous wave (CW) power at high temperature, particularly those having wavelengths that can be useful in infrared countermeasures, thermal collimating aiming devices, gas and other molecular sensing,
and/or other applications, at high environmental temperatures, particularly at longer wavelengths of 7 µm and above.

EP 2 461 435A1, US 2013/0266036, FEDERICO CAPASSO ET AL, "High-Performance Superlattice Quantum Cascade Lasers", IEEE JOURNAL OF SELECTED TOPICS IN QUANTUM ELECTRONICS, IEEE SERVICE CENTER, PISCATAWAY, NJ, US, (199906), vol. 5, no. 3, ISSN 1077-260X, XP011062515 [X] 1, and EP 1 133 035 A2 respectively relate to quantum cascade laser structures comprising a plurality of quantum wells and a plurality of barriers defining an active region, wherein one end of the active region is bordered by an injector barrier, and wherein two or more adjacent first quantum wells of the plurality in the plurality of quantum wells that define the active region are positioned next to the injector barrier and each have a width narrower than the widths of two or more succeeding quantum wells in the plurality of quantum wells that define the active region.

### BRIEF SUMMARY

The present invention as defined by claim 1 is directed to quantum cascade devices having an active region beginning with two or more thin wells. More specifically, a quantum cascade laser structure is disclosed comprising a plurality of quantum wells and a plurality of barriers, at least a portion of which define an active region, one end of said active region being bordered by an injector barrier, wherein two or more adjacent quantum wells of the portion of quantum wells that define the active region are positioned next to the injector barrier and each of the two or more wells have a width narrower than the widths of two or more succeeding quantum wells in the plurality of quantum wells that define the active region, and wherein the active region has a stepped-well configuration wherein a final last quantum well at the other end of the active region has a lower minimum band energy level than an adjacent quantum well of the active region. The resulting active region has increased lifetime of the transition from the upper to the lower photon emission energy state, resulting in higher efficiencies and better overall performance for devices emitting or lasing at long wavelengths (> 7 µm).

### BRIEF DESCRIPTION OF THE SEVERAL VIEWS OF THE DRAWINGS

The following detailed description of specific embodiments of the present disclosure can be best understood when read in conjunction with the following drawings, where like structure is indicated with like reference numerals and in which:
Figure 1 depicts a band diagram, illustrating successive quantum well and barrier energy levels and thicknesses in an existing quantum cascade structure including an active region;
Figure 2 depicts a band diagram according to an example of a quantum well active region of the present disclosure, useful for understanding the present invention, illustrating successive quantum well and barrier energy levels and thicknesses in an existing quantum cascade structure including an active region having at least two thin wells at the beginning of the active region (immediately after an injector barrier, before two or wider quantum wells);
Figure 3 depicts a band diagram according to an embodiment of a quantum well active region of the present invention, illustrating successive quantum well and barrier energy levels and thicknesses in an existing quantum cascade structure including an active region having at least two thin wells at the beginning of the active region (immediately after an injector barrier, before two or wider quantum wells) and a stepped-well configuration in which at least a final last quantum well of the active region has a lower minimum energy level than at least an adjacent quantum well of the active region;
Figure 4 depicts a pulsed light-current-voltage (LIV) curve of a submounted QCL chip utilizing the improved active region structure of Figure 3; and
Figure 5 depicts a continuous wave (CW) light-current-voltage (LIV) curve of a submounted QCL chip utilizing the improved active region structure of Figure 3.

### DETAILED DESCRIPTION

The present disclosure teaches the utilization two thin wells in the active region of a quantum cascade device such as a QCL to increase the lifetime of electrons in the upper lasing state and improve laser performance (the lifetime of the upper lasing state τ₄ ,specifically by lengthening the transition lifetime τ₄₃ of the transition from the upper photon emission or lasing state to the lower photon emission or lasing state in a two-phonon, four-level quantum cascade device. Lengthening this transition is beneficial in long wavelength quantum cascade devices (from 7µm upwards) because as the wavelength increases, the energy gap between the upper emission state 4 and the lower emission state 3 decreases, resulting in lower transition lifetime τ₄₃ of the transition from the upper photon emission or lasing state to the lower photon emission or lasing state. Based on rate equations of a QCL system (with 4 levels), the gain factor g or internal efficiency ηi is proportional to τ4 (1-τ3/τ43), where τ3 is the lifetime of lower laser state 3, τ4 is the lifetime of upper laser state 4, and 1/ τ4=1/τ43+1/τ42+1/τ41+.... Smaller τ43 thus results in smaller τ4, and therefore smaller gain factor and internal efficiency. Lengthening τ43 thus can provide improved efficiency in long wavelength quantum cascade devices (7µm and upwards).

While the energy gap must remain small to produce the desire long wavelengths, the lifetime τ43 is also affected by the degree of spatial overlap between the two energy states, with greater overlap resulting in shorter lifetime.

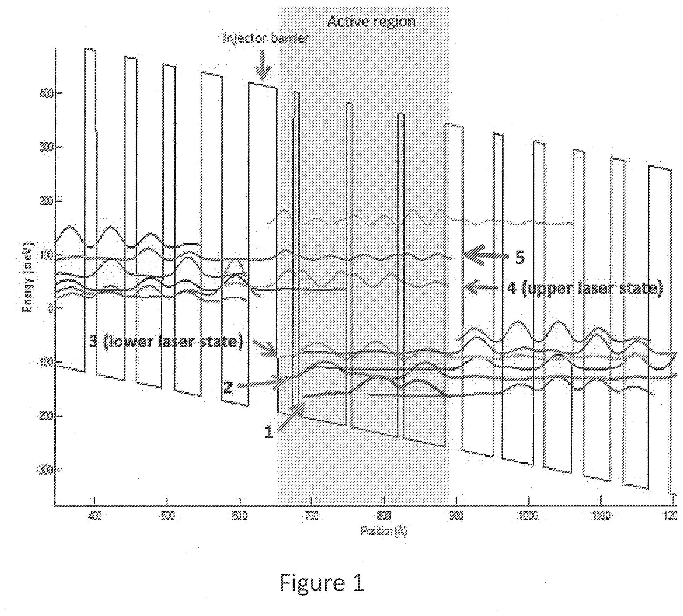

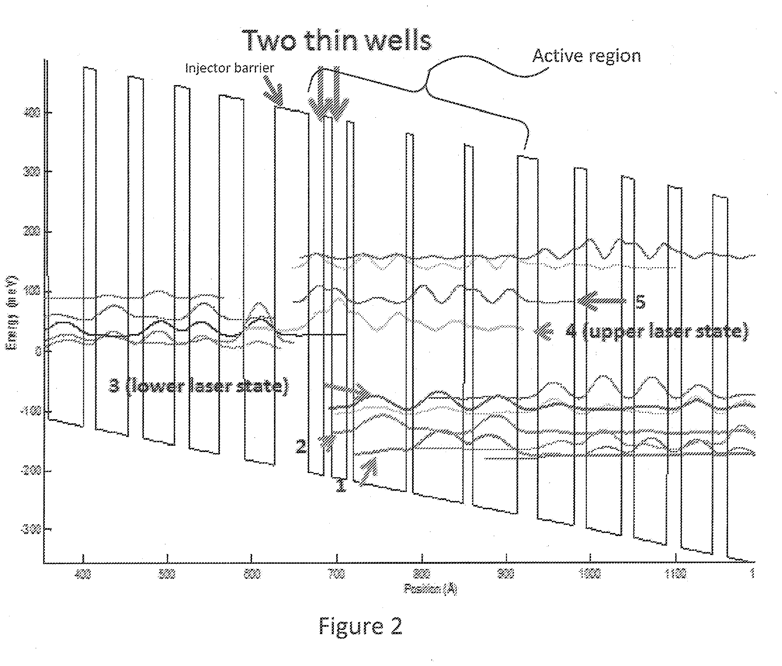

Figure 2 depicts a band diagram according to an example of a quantum well active region of the present disclosure, illustrating successive quantum well and barrier energy levels and thicknesses in an existing quantum cascade structure including an active region having at least two thin wells at the beginning of the active region (immediately after an injector barrier, before two or more wider quantum wells). With Two thin wells, instead of one, placed after the injector barrier, the wave function of the upper emission state 4 has an increased portion located in the thin wells, but the lower emission state 3 cannot penetrate into the thin wells, because the energy level of the lower laser state is much below the ground state of the thin quantum wells. In this way, the overlap between upper and lower laser states is reduced, and the lifetime τ43 is increased. For example, the lifetime τ43 increases from 3.7 ps in the regular structure shown in Figure 1 to 5.5 ps in the modified structure shown in Figure 2, although the two structures have same lasing transition energy which is about 133 meV (corresponding to a lasing wavelength of 9.4 µm).

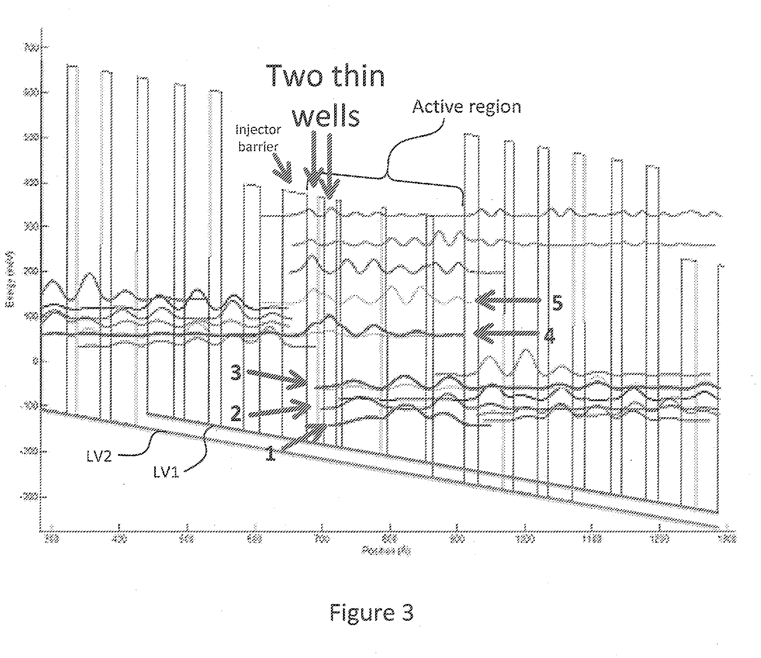

The use of two (or more) thin quantum wells at the beginning of the active region may be beneficially applied in conjunction with the stepped well active region previously disclosed by the present inventors and/or their colleagues in US Provisional Application 61/564375, filed 29 November 2011, and US Regular Application 13/661559, filed 26 October, 2012, published as US 2013/0136148 A1 on 30 May, 2013. Figure 3 depicts a band diagram of such an embodiment of a quantum well active region of the present invention, illustrating successive quantum well and barrier energy levels and thicknesses in an existing quantum cascade structure including an active region having at least two thin wells at the beginning of the active region (immediately after an injector barrier, before two or more wider quantum wells) together with a stepped-well configuration in which at least a final last quantum well of the active region has a lower minimum energy level than at least an adjacent quantum well of the active region. The band diagram of Figure 3 has an emission wavelength of 10.3 µm. As an example, the growth structure of one stage/period of active core is listed in Table 1 below. The thin wells in this example are marked with an asterisk.

**Table I**

| | |
|---|---|
| Ga_{0.372}In_{0.628}As (well) | 36 Å |
| Al_{0.64}In_{0.36}As (barrier) | 15 Å |
| Ga_{0.372}In_{0.628}As | 38 Å |
| Al_{0.64}ID_{0.36}As | 16 Å |
| Ga_{0.465}In_{0.535}As | 39 Å |
| Al_{0.64}In_{0.36}As | 16 Å |
| Ga_{0.465}In_{0.535}As | 37 Å |
| Al_{0.64}In_{0.36}As | 18 Å |
| Ga_{0.465}In_{0.535}As | 32.5 Å |
| Al_{0.5}In_{0.5}As | 23 Å |
| Ga_{0.465}In_{0.535}As | 33 Å |
| Al_{0.5}In_{0.5}As | 37 Å |
| Ga_{0.465}In_{0.535}As | 17 Å * |
| Al_{0.5}In_{0.5}As | 9 Å |
| Ga_{0.465}In_{0.535}As | 18 Å * |
| Al_{0.5}In_{0.5}As | 7 Å |
| Ga_{0.465}In_{0.535}As | 59 Å |
| Al_{0.5}In_{0.5}As | 8 Å |
| Ga_{0.465}In_{0.535}As | 58 Å |
| Al_{0.5}In_{0.5}As | 11 Å |
| Ga_{0.372}In_{0.628}As | 45 Å |
| Al_{0.64}In_{0.36}As | 22 Å |
| Ga_{0.372}In_{0.628}As | 38 Å |
| Al_{0.64}In_{0.36}As | 14 Å |

The laser transition energy is about 118 meV, corresponding to 10.6 µm. The lifetime τ43 is about 4.8 ps. It is about 40% higher than the value typical for a QCL at this wavelength which is 3.5ps. Further, the gap between energy levels 4 and 5 (the upper emission level and the first parasitic level above the upper emission level) is increased by the stepped well active region, further increasing the efficiency of the quantum cascade device employing this active region.

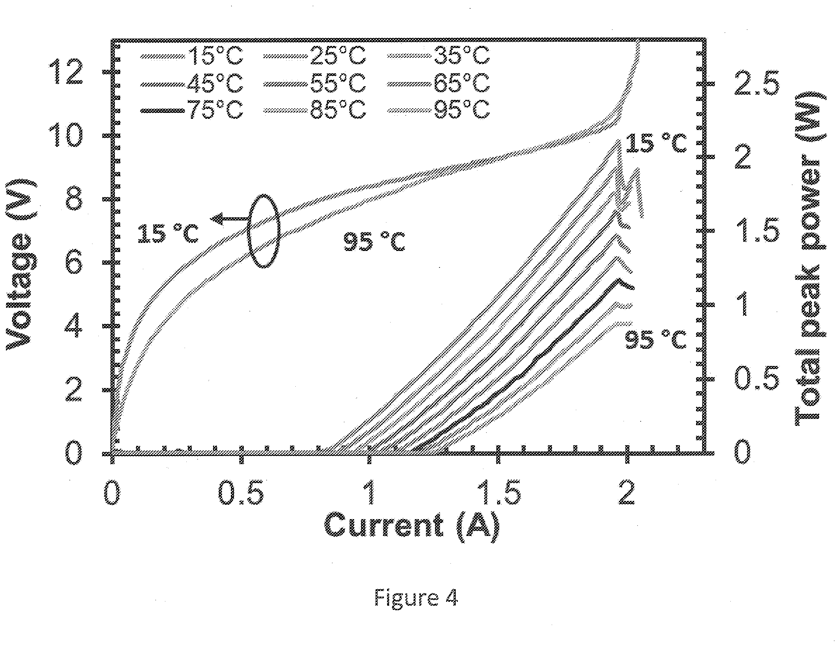

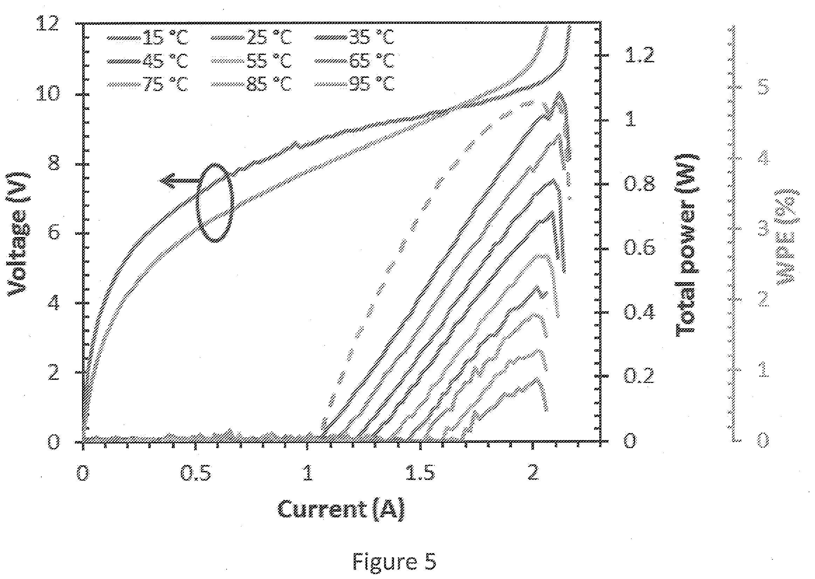

QCLs based on this structure were grown, fabricated, and tested. The pulsed and continuous wave (CW) light-current-voltage (LIV) curves of a submounted QCL chip from this example embodiment of the disclosed active region structure, are shown in Figures 4 and 5, respectively. The tested chip had a 6mm long cavity and 9.5 µm wide stripe. It lased near 10.7 µm. With this device a maximum peak power of 2.1 W was demonstrated, and a maximum pulsed WPE of 10.2 %. CW output power of 1.1W was also demonstrated, and a maximum kink-free CW output power of 1W, and a maximum CW WPE of 4.8%.

As may be seen in the Figures, the tested device also showed good temperature performance. At 95°C, the maximum CW output power still reached 200 mW. This is the first known QCL with wavelength longer than 10 µm with high power (>1W) CW output at room temperature. Another test QCL with a slightly wider stripe (11.5 µm) demonstrated 1.3W CW output power at 15 °C.

## Claims

1. A quantum cascade laser structure comprising a plurality of quantum wells and a plurality of barriers, at least a portion of which define an active region, one end of said active region bordered by an injector barrier, wherein:
two or more adjacent quantum wells of said portion of quantum wells that define the active region are positioned next to the injector barrier and each have a width narrower than the widths of two or more succeeding quantum wells in the plurality of quantum wells that define the active region, and
wherein the active region has a stepped-well configuration wherein a final last quantum well at the other end of the active region has a lower minimum band energy level than an adjacent quantum well of the active region.

## Patentansprüche

1. Quantenkaskadenlaserstruktur umfassend eine Mehrzahl von Quantentöpfen und eine Mehrzahl von Barrieren, von denen zumindest ein Abschnitt eine aktive Region definiert, wobei zumindest ein Ende der aktiven Region durch eine Injektor-Barriere begrenzt ist, wobei:
zwei oder mehrere benachbarte Quantentöpfe des Abschnitts von Quantentöpfen, welche die aktive Region definieren, neben der Injektor-Barriere positioniert sind und ein jeder eine Breite aufweist, die schmäler als die Breiten von zwei oder mehreren nachfolgenden Quantentöpfen in der Mehrzahl von Quantentöpfen ist, welche die aktive Region definieren, und
wobei die aktive Region eine Stufentopf-Auslegung aufweist, wobei ein allerletzter Quantentopf am anderen Ende der aktiven Region einen geringeren Bandenergiepegel aufweist als ein benachbarter Quantentopf der aktiven Region.

## Revendications

1. Structure de laser à cascade quantique qui comprend une pluralité de puits quantiques et une pluralité de barrières parmi lesquelles au moins une partie définit une région active, au moins une extrémité de la région active étant délimitée par une barrière injecteur, structure dans laquelle :
deux ou plusieurs puits quantiques voisins de la partie de puits quantiques qui définissent la région active sont positionnés à côté de la barrière injecteur et chacun d'eux présente une largeur qui est inférieure aux largeurs de deux ou plusieurs puits quantiques suivants dans la pluralité de puits quantiques qui définissent la région active, et
la région active présente une configuration à puits à étages, un dernier puits quantique à l'autre extrémité de la région active présentant un niveau d'énergie de bande plus faible qu'un puits quantique voisin de la région active.
